# EUROPÄISCHE PATENTSCHRIFT

(11) **EP 2 750 960 B1**
(45) Veröffentlichungstag und Bekanntmachung des Hinweises auf die Patenterteilung: **25.11.2020**
(21) Anmeldenummer: 12751314.1
(22) Anmeldetag: 21.08.2012
(51) Int. Cl.: B62D 5/04, H02P 29/02, H02P 27/08

(54) **ELEKTROMOTOR MIT EINER TESTSTROMQUELLE**
ELECTRICAL MOTOR HAVING A TEST CURRENT SOURCE
MOTEUR ÉLECTRIQUE AYANT UNE SOURCE DE COURANT D'ESSAI

(30) Priorität: 01.09.2011 DE 102011081942
(43) Veröffentlichungstag der Anmeldung: 09.07.2014
(73) Patentinhaber: Robert Bosch GmbH, 70442 Stuttgart (DE)
(72) Erfinder: HIRY, Pascal, 71665 Vaihingen/Enz (DE); URBAN, Stephan, 73275 Ohmden (DE)
(86) Internationale Anmeldenummer: PCT/EP2012/066258
(87) Internationale Veröffentlichungsnummer: WO 2013/030043

(56) Entgegenhaltungen:
- DE-A1-102007 051 004
- DE-B3- 10 359 235
- JP-A- 2009 274 686
- US-A1- 2011 156 626

## Beschreibung

### Stand der Technik

Die Erfindung betrifft einen elektronisch kommutierten Elektromotor. Der elektronisch kommutierte Elektromotor weist wenigstens zwei, bevorzugt wenigstens drei Statorspulen und einen insbesondere permanentmagnetisch ausgebildeten Rotor auf. Der Elektromotor weist auch eine Leistungsendstufe mit Halbleiterschaltern auf, wobei die Leistungsendstufe für jede Statorspule ein Halbleiterschalterpaar aufweist. Der Elektromotor weist auch eine Steuereinheit auf, welche mit der Leistungsendstufe verbunden und ausgebildet ist, die Halbleiterschalter zum Bestromen der Statorspulen zum Erzeugen eines magnetischen Drehfeldes anzusteuern. Die Leistungsendstufe weist wenigstens einen, insbesondere für jede Statorspule einen Halbleitertrennschalter auf, wobei der Halbleitertrennschalter einen Ausgang eines Halbleiterschalterpaares mit einem Ausgang der Leistungsendstufe verbindet, wobei der Ausgang der Leistungsendstufe mit einer Statorspule verbunden ist.

Bei aus dem Stand der Technik bekannten elektronisch kommutierten Elektromotoren, insbesondere bei Elektromotoren einer Servolenkung eines Kraftfahrzeugs, besteht das Problem, dass defekte Halbleiterschalter, welche kurzgeschlossen sind, das Lenken erschweren, indem ein Lenkmoment durch den defekten Halbleiterschalter erzeugt wird.

In der Offenlegungsschrift DE 102007051004 A1 und DE 103 59 235 B3 ist ein Elektromotor offenbart, bei dem eine Funktion eines Inverters mittels einer Teststromquelle des Elektromotors geprüft werden kann.

### Offenbarung der Erfindung

Die Erfindung ist durch die unabhängige Ansprüche 1 und 5 definiert. Bevorzugte Ausführungsformen sind in abhängigen Ansprüchen definiert.

Erfindungsgemäß ist die Steuereinheit des Elektromotors der eingangs genannten Art mit den Ausgängen der Halbleiterschalterpaare verbunden und ausgebildet, die Halbleiterschalter und die Halbleitertrennschalter zum Öffnen anzusteuern. Bevorzugt ist die Steuereinheit weiter ausgebildet, in wenigstens einen Ausgang eines Halbleiterschalterpaares, bevorzugt in jeden Ausgang der Halbleiterschalterpaare, einen Teststrom einzuspeisen.

Bevorzugt ist die Steuereinheit ausgebildet, an einem Ausgang der Leistungsendstufe erzeugte Ausgangsspannung zu erfassen und in Abhängigkeit der Ausgangsspannung eine Funktion wenigstens eines Halbleiterschalters der Halbleiterschalter zu ermitteln. Dadurch kann vorteilhaft vor einem Betrieb des Elektromotors eine Funktion der Halbleiterschalter getestet werden, ohne den Rotor des Elektromotors zu bewegen. Bevorzugt ist der Teststrom derart ausgebildet, insbesondere derart klein, dass der Rotor des Elektromotors durch den Teststrom nicht bewegt werden kann.

Der Elektromotor weist bevorzugt wenigstens einen mit dem Ausgang der Leistungsendstufe verbundenen Spannungsteiler auf. Mittels des Spannungsteilers kann die am Ausgang der Leistungsendstufe über dem Spannungsteiler abfallende Spannung erfasst werden. Dadurch kann vorteilhaft - beispielsweise vor einem Starten eines Kraftfahrzeugs, die Funktion der Leistungsendstufe eines Elektromotors eines Antriebs eines Elektrofahrzeuges oder einer Servolenkung getestet werden.

Die Halbleiterschalterpaare der Leistungsendstufe bilden bevorzugt gemeinsam eine B6-Brücke. In einer anderen Ausführungsform weist die Leistungsendstufe für jede Statorspule eine H-Brücke auf, wobei die H-Brücke zwei Halbleiterschalterpaare umfasst, deren Ausgänge über die Statorspule miteinander verbunden sind.

In einer bevorzugten Ausführungsform umfasst das Halbleiterschalterpaar einen High-Side-Halbleiterschalter und einen Low-Side-Halbleiterschalter. Die Steuereinheit ist ausgebildet, zum Testen des Low-Side-Halbleiterschalters alle Halbleiterschalter zum Schließen anzusteuern, und in wenigstens einen Ausgang einen Teststrom einzuspeisen und in Abhängigkeit des Teststromes, insbesondere eines am Ausgang der Leistungsendstufe fließenden Teststromes, einen Defekt wenigstens eines Low-Side-Halbleiterschalters zu ermitteln. Wenn bei einem defekten Halbleiterschalter ein Teil des Teststromes über den defekten Halbleiterschalter, insbesondere Low-Side-Halbleiterschalter zu einem Masseanschluss der Leistungsendstufe fließt, so fließt an dem Ausgang der Leistungsendstufe im Vergleich zu einem intakten Halbleiterschalter ein kleinerer Strom. Dieser kleinere Strom verursacht am Ausgang der Leistungsendstufe einen kleineren Spannungsabfall zu einem Masseanschluss hin als bei einem intakten Low-Side-Halbleiterschalter. Bevorzugt ist die Steuereinheit ausgebildet, den Defekt des wenigstens einen Low-Side-Halbleiterschalters in Abhängigkeit des Teststromes am Ausgang der Leistungsendstufe zu ermitteln.

Die Steuereinheit ist bevorzugt ausgebildet, einen Betrag eines Verringerns des Teststromes im Vergleich zu einem Teststrom bei einer nicht defekten Leistungsendstufe am Ausgang der Leistungsendstufe zu erfassen und in Abhängigkeit des Betrages einen Defekt, insbesondere einen Kurzschluss, wenigstens eines Low-Side-Halbleiterschalters zu ermitteln. Beispielsweise verringert sich der Betrag des Teststromes am Ausgang der Leistungsendstufe um ein Drittel bei einem defekten Halbleiterschalter. Das wird insbesondere bei einem in Sternschaltung geschalteten Stator des Elektromotors dadurch bewirkt, dass die Ausgänge der Leistungsendstufe für jede Phase des Elektromotors über die Statorspulen niederohmig miteinander verbunden sind. Somit beträgt die Ausgangsspannung, welche am Ausgang der Leistungsendstufe erfasst werden kann, im Falle eines defekten Low-Side-Halbleiterschalters zwei Drittel der Ausgangsspannung bei intakten Low-Side-Halbleiterschaltern und im Falle von zwei defekten Low-Side-Halbleiterschaltern nur ein Drittel der Ausgangsspannung bei intakten Low-Side-Halbleiterschaltern.

In einer bevorzugten Ausführungsform weist der Elektromotor, insbesondere die Steuereinheit einen Speicher für Datensätze auf, wobei jeder Datensatz einen Wert eines bestimmten Anteils des Teststromwertes für nicht defekte Halbleiterschalter repräsentiert. Die Steuereinheit ist bevorzugt ausgebildet, zum Testen der Leistungsendstufe den Teststrom zu erzeugen und die Ausgangsspannung am Ausgang der Leistungsendstufe zu erfassen und den Wert der Ausgangsspannung mit den entsprechenden Werten der aus dem Speicher ausgelesenen Datensätze zu vergleichen und in Abhängigkeit des Vergleichsergebnisses einen Defekt wenigstens eines Low-Side-Halbleiterschalters zu ermitteln.

Bevorzugt ist die Steuereinheit ausgebildet, einen Defekt eines Halbleitertrennschalters zu ermitteln. Erfindungsgemäß ist die Steuereinheit dazu ausgebildet, zum Testen des Halbleitertrennschalters einen Low-Side-Halbleiterschalter eines Halbleiterschalterpaares zum Schließen anzusteuern, und den mit dem Halbleiterschalterpaar verbundenen Halbleitertrennschalter zum Öffnen anzusteuern und weiter bevorzugt alle Halbleitertrennschalter zum Öffnen anzusteuern und einen Teststrom in wenigstens einen Ausgang eines anderen Halbleiterschalterpaares der Halbleiterschalterpaare einzuspeisen. Die Steuereinheit ist bevorzugt weiter ausgebildet, in Abhängigkeit eines Betrages des Teststromes im Vergleich zu einem Teststrom bei nicht defektem Halbleitertrennschalter eine Funktion des Öffnens, insbesondere einen Defekt, beispielsweise einen Kurzschluss des Halbleitertrennschalters zu ermitteln.

Dadurch kann vorteilhaft - bevorzugt nach einer Prüfung der Halbleiterschalter der Leistungsendstufe, insbesondere einer B6-Brücke eine Leistungsendstufe, die Halbleitertrennschalter getestet werden, insbesondere ob diese in Abhängigkeit eines Steuersignals an einem Steueranschluss, insbesondere einem Gate-Anschluss, ihre Schaltstrecke öffnen beziehungsweise schließen können. Weiter vorteilhaft kann der Teststrom über die Bodydioden der geöffneten Halbleitertrennschalter fließen, in die der Teststrom eingeprägt wurde, so dass das Testergebnis von einer Funktion, insbesondere von einem Defekt der übrigen Halbleitertrennschalter unabhängig ist.

Erfindungsgemäß ist die Steuereinheit ausgebildet, zum Testen eines Halbleitertrennschalters einen Low-Side-Halbleiterschalter eines Halbleiterschalterpaares zum Schließen anzusteuern und den mit dem Halbleiterschalterpaar verbundenen Trennschalter zum Schließen anzusteuern, und bevorzugt wenigstens einen anderen, von dem mit dem zum Schließen angesteuerten Halbleiterpaar verbundenen Halbleitertrennschalter verschiedenen Halbleiterschalter zum Schließen anzusteuern und einen Teststrom in wenigstens einen Ausgang eines anderen Halbleiterschalterpaares der Halbleiterschalterpaare einzuspeisen und in Abhängigkeit eines Betrages des Teststromes im Vergleich zu einem Teststrom bei nicht defektem Halbleitertrennschalter eine Funktion des Schließens des Halbleitertrennschalters zu ermitteln.

Die Erfindung betrifft auch eine Lenkvorrichtung mit einem Elektromotor der vorbeschriebenen Art. Die Lenkvorrichtung ist bevorzugt ausgebildet, ein Einlenken unterstützendes Lenkmoment mittels des Elektromotors zu erzeugen.

Die Erfindung betrifft auch ein Verfahren zum Betreiben eines elektronisch kommutierten Elektromotors, insbesondere des Elektromotors der vorbeschriebenen Art.

Bei dem Verfahren wird vor einem Betrieb des Elektromotors zum Erzeugen eines Drehmoments wenigstens ein Teststrom in einen Ausgang eines Halbleiterschalterpaares einer Leistungsendstufe des Elektromotors eingespeist, wobei das Halbleiterschalterpaar einen High-Side-Halbleiterschalter und einen Low-Side-Halbleiterschalter umfasst, und ein Betrag des über den Halbleitertrennschalter fließenden Teststromes am Ausgang der Leistungsendstufe erfasst wird und in Abhängigkeit des Betrages ein Defekt eines Halbleiterschalters der Leistungsendstufe ermittelt wird.

Bevorzugt werden bei dem Verfahren zum Testen der Low-Side-Halbleiterschalter alle Halbleiterschalter zum Öffnen angesteuert.

Weiter bevorzugt werden bei dem Verfahren zusätzlich alle Halbleitertrennschalter zum Öffnen angesteuert.

Die Erfindung betrifft auch ein Verfahren zum Betreiben eines elektronisch kommutierten Elektromotors. Bevorzugt weist der Elektromotor eine Leistungsendstufe auf, die für jede Statorspule des Elektromotors ein Halbleiterschalterpaar umfassend einen High-Side-Halbleiterschalter und einen Low-Side-Halbleiterschalter und wenigstens einen Halbleitertrennschalter aufweist, wobei der Halbleitertrennschalter einen Ausgang des Halbleiterschalterpaares mit einer Statorspule verbindet.

Bei dem Verfahren wird vor einem Betrieb zum Erzeugen eines Drehmoments wenigstens ein Teststrom in einen Ausgang eines Halbleiterschalterpaares eingespeist und ein Betrag des über den Halbleitertrennschalter fließenden Teststromes erfasst und in Abhängigkeit des Betrages ein Defekt eines Halbleitertrennschalters der Leistungsendstufe ermittelt.

Die Erfindung wird nun im Folgenden anhand von Figuren und weiteren Ausführungsbeispielen beschrieben. Weitere vorteilhafte Ausführungsvarianten ergeben sich aus den in den Figuren und in den abhängigen Ansprüchen beschriebenen Merkmalen.

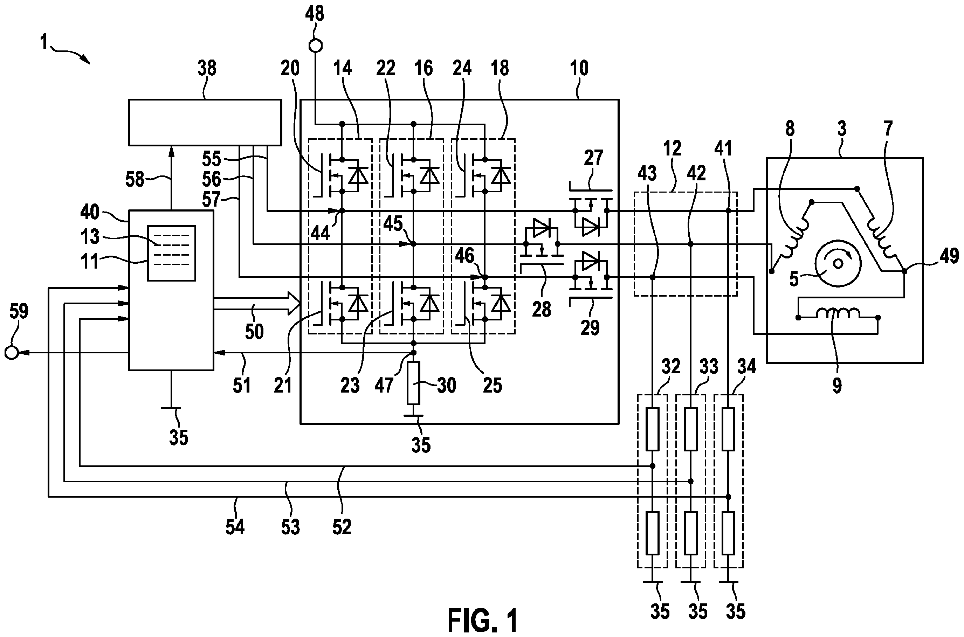

Figur 1 zeigt ein Ausführungsbeispiel für einen elektronisch kommutierten Elektromotor.

Figur 1 zeigt ein Ausführungsbeispiel für einen elektronisch kommutierten Elektromotor 1. Der Elektromotor 1 weist einen Stator 3 und einen permanentmagnetisch ausgebildeten Rotor 5 auf. Der Stator 3 umfasst in diesem Ausführungsbeispiel drei Statorspulen, nämlich die Statorspule 7, die Statorspule 8 und die Statorspule 9. Der Elektromotor 1 weist auch eine Leistungsendstufe 10 auf. Die Leistungsendstufe 10 ist ausgangsseitig über einen Ausgang 12 mit dem Stator 3, und dort mit den Statorspulen 7, 8 und 9 verbunden. Die Leistungsendstufe 10 ist in diesem Ausführungsbeispiel als B6-Brücke ausgebildet. Dazu weist die Leistungsendstufe 10 drei Halbleiterschalterpaare 14, 16 und 18 auf. Das Halbleiterschalterpaar 14 weist einen High-Side-Halbleiterschalter 20 und einen Low-Side-Halbleiterschalter 21 auf. Das Halbleiterschalterpaar 16 weist einen High-Side-Halbleiterschalter 22 und einen Low-Side-Halbleiterschalter 23 auf. Das Halbleiterschalterpaar 18 weist einen High-Side-Halbleiterschalter 24 und einen Low-Side-Halbleiterschalter 25 auf. Die Halbleiterschalter sind in diesem Ausführungsbeispiel als Feldeffekt-Transistoren, insbesondere MOS-FET (MOS-FET = Metal-Oxide-Field-Effect-Transistor) oder MIS-FET (MIS-FET = Metal-Insulated-Field-Effect-Transistor) ausgebildet. Die Halbleiterschalterpaare 14, 16 und 18 weisen jeweils einen Ausgang auf. Das Halbleiterschalterpaar 14 weist einen Ausgang 44 auf, welcher mit einem Source-Anschluss des Halbleiterschalters 20 und mit einem Drain-Anschluss des Halbleiterschalters 21 verbunden ist. Das Halbleiterschalterpaar 16 weist einen Ausgang 45 auf, welcher mit einem Source-Anschluss des Halbleiterschalters 22 und mit einem Drain-Anschluss des Halbleiterschalters 23 verbunden ist. Das Halbleiterschalterpaar 18 weist einen Ausgang 46 auf, welcher mit dem Source-Anschluss des Halbleiterschalters 24 und mit einem Drain-Anschluss des Halbleiterschalters 25 verbunden ist. Die High-Side-Halbleiterschalter 20, 22 und 24 sind jeweils mit ihren Drain-Anschlüssen mit einem Anschluss 48 für eine Zwischenkreisspannung verbunden. Die Source-Anschlüsse der Low-Side-Halbleiterschalter 21, 23 und 25 sind jeweils mit einem Verbindungsknoten 47 verbunden, welcher über einen Shunt-Widerstand 30 mit einem Masseanschluss 35 verbunden ist.

Der Ausgang 44 des Halbleiterschalterpaares 14 ist über einen Halbleitertrennschalter 27 mit dem Ausgang 12 und dort mit einem Verbindungsknoten 41 verbunden. Der Ausgang 45 ist über einen Halbleitertrennschalter 28 mit dem Ausgang 12 und dort mit einem Verbindungsknoten 42 verbunden. Der Ausgang 46 ist über einen Halbleitertrennschalter 29 mit dem Ausgang 12 und dort mit einem Verbindungsknoten 43 verbunden. Der Verbindungsknoten 41 des Ausgangs 12 ist mit einem ersten Anschluss der Statorspule 7 verbunden, der Verbindungsknoten 42 ist mit einem ersten Anschluss der Statorspule 8 verbunden und der Verbindungsknoten 43 des Ausgangs 12 ist mit einem ersten Anschluss der Statorspule 9 verbunden. Die zweiten Anschlüsse der Statorspulen 7, 8 und 9 sind jeweils mit einem gemeinsamen Sternpunktanschluss der Statorspulen verbunden. Die Statorspulen 7, 8 und 9 sind somit in diesem Ausführungsbeispiel in Sternschaltung miteinander verbunden.

Der Elektromotor 1 weist auch eine Steuereinheit 40 auf. Die Steuereinheit 40 ist ausgangsseitig über eine in diesem Ausführungsbeispiel mehrkanalige Verbindung 50 mit der Leistungsendstufe 10 und dort mit Steueranschlüssen der Halbleiterschalter 20, 21, 22, 23, 24 und 25 verbunden. Die Steuereinheit 40 ist über die Verbindung 50 mit Steueranschlüssen der Halbleitertrennschalter 27, 28 und 29 verbunden. Die Steuereinheit 40 ist eingangsseitig über drei Spannungsteiler 32, 33 und 34 mit dem Ausgang 12 verbunden und ist ausgebildet, in Abhängigkeit von den Spannungsteilern 32, 33 und 34 erzeugten Ausgangsspannungen Steuersignale zum Ansteuern der Halbleiterschalterpaare 14, 16 und 18 zu erzeugen, sodass der Stator 3 von der Leistungsendstufe 10 zum Erzeugen eines magnetischen Drehfeldes zum Drehbewegen des Rotors 5 bestromt werden kann.

Die von den Spannungsteilern 32, 33 und 34 im Betrieb des Elektromotors 1 erfassten Spannungen repräsentieren dabei ein pulsweitenmoduliertes Ansteuermuster, mit dem der Stator 3 von der Leistungsendstufe 10 - gesteuert durch die Steuereinheit 40 - bestromt wird. Der Stator 3 kann beispielsweise zusätzlich einen - nicht dargestellten - Rotorpositionssensor aufweisen, welcher ausgebildet ist, eine Rotorposition des Rotors 5 zu erfassen und ein die Rotorposition repräsentierendes Rotorpositionssignal zu erzeugen. Der Rotorpositionssensor ist in dieser Ausführungsvariante mit der Steuereinheit 40 verbunden, welche ausgebildet ist, in Abhängigkeit des Rotorpositionssignals die Steuersignale zum Drehbewegen des Rotors 5 zu erzeugen.

Die Steuereinheit 40 ist eingangsseitig über eine Verbindungsleitung 51 mit dem Verbindungsknoten 47 verbunden. Die Steuereinheit 40 ist auch mit dem Masseanschluss 35 verbunden. Die Steuereinheit 40 ist ausgebildet, eine über dem Shunt-Widerstand 30 abfallende, einen durch die Halbleiterschalterpaare 14, 16 und 18 fließenden Strom repräsentierende Spannung zu erfassen.

Der Spannungsteiler 32 weist in diesem Ausführungsbeispiel zwei seriell miteinander verbundene Widerstände auf und verbindet den Verbindungsknoten 43 mit dem Masseanschluss 35. Der Spannungsteiler 33 verbindet den Verbindungsknoten 42 mit dem Masseanschluss 35, und der Spannungsteiler 34 verbindet den Verbindungsknoten 41 mit dem Masseanschluss 35. Der Spannungsteiler 32 ist ausgangsseitig über eine Verbindungsleitung 52 mit der Steuereinheit 40 verbunden. Der Spannungsteiler 33 ist ausgangsseitig über eine Verbindungsleitung 53 mit der Steuereinheit 40 verbunden. Der Spannungsteiler 34 ist ausgangsseitig über eine Verbindungsleitung 54 mit der Steuereinheit 40 verbunden. Die Steuereinheit 40 ist ausgangsseitig über eine Verbindungsleitung 58 mit einer Teststromquelle 38 des Elektromotors 1 verbunden. Die Teststromquelle 38 ist ausgangsseitig über eine Verbindungsleitung 55 mit dem Ausgang 44 des Halbleiterschalterpaares 14 verbunden. Die Teststromquelle 38 ist ausgangsseitig über eine Verbindungsleitung 56 mit dem Ausgang 45 des Halbleiterschalterpaares 16 verbunden. Die Teststromquelle 38 ist ausgangsseitig über eine Verbindungsleitung 57 mit dem Ausgang 46 des Halbleiterschalterpaares 18 verbunden. Die Teststromquelle 38 ist ausgebildet, in Abhängigkeit eines über die Verbindungsleitung 58 empfangenen Steuersignals wenigstens einen Teststrom zu erzeugen und diesen ausgangsseitig auszugeben. Der Teststrom kann somit in einem Ausgang wenigstens eines Halbleiterschalterpaares der Halbleiterschalterpaare 14, 16 und 18 eingespeist werden.

Die Funktionsweise des Elektromotors 1 wird nun im Folgenden erläutert:
Die Steuereinheit 40 ist ausgebildet, in einem Testschritt die Halbleiterschalter der Halbleiterschalterpaare 14, 16 und 18 jeweils zum Öffnen ansteuern. Die Halbleitertrennschalter 27, 28 und 29 werden von der Steuereinheit 40 in diesem Testschritt ebenfalls zum Öffnen angesteuert. Die Steuereinheit 40 ist ausgebildet, zum Testen der Halbleiterschalter der Halbleiterschalterpaare 14, 16 und 18 ein Steuersignal zum Aktivieren der Teststromquelle 38 zu erzeugen und dieses über die Verbindungsleitung 58 auszugeben. Von der Teststromquelle werden in diesem Testschritt nacheinanderfolgend jeweils ein Teststrom in die Ausgänge 44, 45 und 46 eingespeist. Die Halbleitertrennschalter 27, 28 und 29 sind jeweils als Halbleitertrennschalter ausgebildet und weisen jeweils eine Bodydiode auf. Der von der Teststromquelle 38 in den Ausgang 44 eingespeiste Teststrom fließt dann über die Bodydiode des Halbleitertrennschalters 27 und weiter über den Verbindungsknoten 41 zur Statorspule 7 und weiter von dem Sternpunktanschluss 49 über die Statorspulen 8 und 9 und weiter über die Spannungsteiler 32, 33 und 34 zum Masseanschluss 35. Die Spannungsteiler 32, 33 und 34 können dann jeweils ausgangsseitig ein Ausgangssignal erzeugen und dieses an die Steuereinheit 40 über die Verbindungsleitung 54 senden. Das Ausgangssignal der Spannungsteiler 32, 33 und 34 repräsentiert dann den von der Teststromquelle 38 erzeugten und in den Ausgang 44 eingespeisten Teststrom, der über den Ausgang 12 fließt. Die Steuereinheit 40 ist ausgebildet, das von dem Spannungsteiler 32, 33 oder 34 erzeugte Ausgangssignal mit einem vorbestimmten, abgespeicherten Referenz-Datensatz zu vergleichen und in Abhängigkeit des Vergleichsergebnisses den Rotor 3 zum Drehbewegen des Rotors 5 anzusteuern. Das Vergleichsergebnis repräsentiert dabei die Funktion des Low-Side-Halbleiterschalters 21. Im Falle eines Defektes des Low-Side-Halbleiterschalters 21 weicht nämlich die von den Spannungsteilern 32, 33 und 34 erzeugte Ausgangsspannung, repräsentiert durch das zuvor erwähnte Ausgangssignal der Spannungsteiler von dem Spannungswert ab, der einem intakten Low-Side-Halbleiterschalter 21 entspricht, der durch den zuvor erwähnten Datensatz repräsentiert ist.

Die Steuereinheit 40 kann dazu einen Speicher 11 aufweisen, in dem der Datensatz und beispielsweise weitere Datensätze abgespeichert sind. Der Datensatz 13 ist beispielhaft bezeichnet. Die Steuereinheit 40 ist mit einem Ausgang 59 verbunden und ist ausgebildet, im Falle eines mittels des Teststroms erfassten defekten Halbleiterschalters der Leistungsendstufe 10 ein den Defekt repräsentierendes Fehlersignal zu erzeugen und dieses an den Ausgang 59 zu senden.

Bei intakten Low-Side-Halbleiterschaltern 21, 23 und 25 entspricht das von dem Spannungsteiler 34 erzeugte Ausgangssignal einem Spannungswert, welcher beispielsweise durch einen Datensatz repräsentiert ist, der im Speicher 11 abgespeichert ist. Die Steuereinheit 40 kann den Datensatz aus dem Speicher 11 auslesen und die von den Spannungsteilern 32 und/oder 33 erzeugten Ausgangsspannungen mit Spannungswerten vergleichen, die durch wenigstens einen in dem Speicher 11 abgespeicherten Datensatz repräsentiert sind und ein Vergleichsergebnis erzeugen, das den Defekt wenigstens eines Low-Side-Halbleiterschalters repräsentiert.

Bei nicht defekten Low-Side-Halbleiterschaltern entspricht der eingespeiste Teststrom einem vorbestimmten Wert, repräsentiert durch das Ausgangssignal der Spannungsteiler 32, 33, oder 34, da der von der Teststromquelle 38 erzeugte Teststrom, der in den Ausgang 44 des Halbleiterschalterpaares 14 eingespeist wird, über die Bodydiode des Halbleitertrennschalters 27, die Statorspule 7 und über die - im Vergleich zu den Spannungsteilern 32, 33 und 34 niederohmigen Statorspulen 8 und 9 über die Spannungsteiler 32, 33 und über den Spannungsteiler 34 zum Masseanschluss 35 fließt. Wenn der Low-Side-Halbleiterschalter 21 defekt ist, so fließt der in den Ausgang 44 eingespeiste Teststrom über den defekten Low-Side-Halbleiterschalter 21, der durch den Defekt niederohmig verbunden ist, über den Shunt-Widerstand 30 zum Masseanschluss 35. Die Steuereinheit 40 kann beispielsweise dazu ausgebildet sein, den Defekt eines Low-Side-Halbleiterschalters zusätzlich in Abhängigkeit einer über dem Shunt-Widerstand 30 abfallenden, und über die Verbindungsleitung 51 empfangenen Spannung zu erfassen. Die über dem Shunt-Widerstand 30 abfallende Spannung repräsentiert den durch den Shunt-Widerstand 30 fließenden Strom. Der von den Spannungsteilern 32 und 33 erfasste Teststrom, der über die Statorspule 7 und die Spannungsteiler 32, 33 und 34 fließt, ist bei defektem Low-Side-Halbleiterschalter 21 kleiner als bei intaktem Low-Side-Halbleiterschalter. Die Steuereinheit 40 ist ausgebildet, den Defekt in Abhängigkeit eines Vergleichs der von dem Spannungsteiler 32 und/oder 33 erzeugten Ausgangsspannung mit einem Spannungswert, repräsentiert durch einen Datensatz, zu erfassen. Die Steuereinheit 40 kann zum Testen der Low-Side-Halbleiterschalter 23 und 25 in entsprechender Weise einen Teststrom in den Ausgang 45 beziehungsweise in den Ausgang 46 einspeisen. Die Steuereinheit kann so in Abhängigkeit des mittels der Spannungsteiler 32, 33 oder 34 erfassten Teststromes, der über den Ausgang 12 fließt, den Defekt wenigstens eines Low-Side-Halbleiterschalters ermitteln. Die Steuereinheit 40 ist in einer anderen Ausführungsform ausgebildet, alle drei Ausgänge 44, 45 und 46 gleichzeitig zu bestromen. Im Falle eines defekten Low-Side-Halbleiterschalters verringert sich der mittels der Spannungsteiler 32, 33 und 34 erfasste Teststrom auf zwei Drittel eines Spannungswertes im Vergleich zu intakten Low-Side-Halbleiterschaltern. Im Falle von zwei defekten Low-Side-Halbleiterschaltern entspricht der Teststrom der von den Spannungsteilern 32, 33 und 34 am Ausgang 12 erfasst werden kann, einem Drittel eines Stromwertes bei intakten Low-Side-Halbleiterschaltern.

Die High-Side-Halbleiterschalter 20, 22 und 24 können ohne Einspeisen eines Teststroms in den Ausgang 44, den Ausgang 45 und den Ausgang 46 getestet werden. Wenn nämlich ein High-Side-Halbleiterschalter defekt ist, so ist die Schaltstrecke des High-Side-Halbleiterschalters niederohmig verbunden. Dadurch liegt die am Anschluss 48 anliegende Zwischenkreisspannung an dem Ausgang des Halbleiterschalterpaares an, dessen High-Side-Halbleiterschalter defekt ist. Im Falle nicht defekter High-Side-Halbleiterschalter müssen daher die mittels der Spannungsteiler 32, 33 und 34 erfassten Spannungen an den Verbindungsknoten 41, 42 beziehungsweise 43 Null sein oder einem kleinen Wert entsprechen. Im Falle eines defekten High-Side-Halbleiterschalters der Leistungsendstufe 10 entspricht die an dem Ausgang 12 erfasste Spannung dem defekten High-Side-Halbleiterschalter.

Die Steuereinheit 40 ist beispielsweise ausgebildet, in dem zu dem vorbeschriebenen Testschritt zum Testen der High-Side-Halbleiterschalter die Teststromquelle 38 nicht zu aktivieren. Die von den Spannungsteilern 32, 33 und 34 erfassten Ausgangsspannungen sind dann bei intakten High-Side-Halbleiterschaltern jeweils Null oder entsprechend einem kleinen Spannungswert.

Die Steuereinheit 40 ist beispielsweise ausgebildet, zum Testen eines Öffnens der Halbleitertrennschalter 27, 28 und 29 der Leistungsendstufe 40 ein Steuersignal zum Erzeugen eines Teststromes an die Teststromquelle 38 über die Verbindungsleitung 58 zu senden. Die Teststromquelle 38 kann dann beispielsweise über die Verbindungsleitung 56 einen Teststrom in den Ausgang 45 des Halbleiterschalterpaares 16 und/oder über die Verbindungsleitung 57 einen Teststrom in den Ausgang 46 des Halbleiterschalterpaares 18 einspeisen. Die Steuereinheit 40 steuert während dieses Testschritts zum Testen des Halbleitertrennschalters 27 den Low-Side-Halbleiterschalter des Halbleiterschalterpaares 14, das ausgangsseitig mit dem Halbleitertrennschalter 27 verbunden ist, zum Schließen an. Die übrigen Halbleiterschalter der Leistungsendstufe 10 werden von der Steuereinheit 40 zum Öffnen angesteuert. Die Halbleitertrennschalter 27, 28 und 29 der Leistungsendstufe 10 werden von der Steuereinheit 40 zum Öffnen angesteuert. Die Steuereinheit 40 ist ausgebildet, in Abhängigkeit der resultierenden Spannung am Ausgang 12 einen Defekt des Halbleitertrennschalters 27 zu ermitteln. Wenn der Halbleitertrennschalter 27 nämlich defekt ist, also kurzgeschlossen ist und nicht öffnen kann, wird das Potential am Verbindungsknoten 41 - und das der Verbindungsknoten 42 und 43 über die niederohmigen Statorspulen - von dem geschlossenen Low-Side-Halbleiterschalter 21 auf Masse gezogen. Am Ausgang 12 kann dann keine oder nur eine kleine Spannung im Vergleich zu einem intakten Halbleitertrennschalter 27 erfasst werden.

Der Halbleitertrennschalter 28 kann zum Testen eines Öffnens in gleicher Weise durch Einspeisen eines Teststroms in die Ausgänge 44 und/oder 47 und Schließen des Low-Side-Halbleiterschalters 23 des Halbleiterschalterpaares 16, mit dessen Ausgang 45 der Halbleitertrennschalter 28 verbunden ist, getestet werden.

Der Halbleitertrennschalter 29 kann zum Testen eines Öffnens in gleicher Weise durch Einspeisen eines Teststroms in die Ausgänge 44 und/oder 45 und Schließen des Low-Side-Halbleiterschalters 25 des Halbleiterschalterpaares 18, mit dessen Ausgang 46 der Halbleitertrennschalter 29 verbunden ist, getestet werden.

Die Steuereinheit 40 ist beispielsweise ausgebildet, zum Testen eines Schließens der Halbleitertrennschalter 27, 28 und 29 der Leistungsendstufe 40 ein Steuersignal zum Erzeugen eines Teststromes an die Teststromquelle 38 über die Verbindungsleitung 58 senden. Die Teststromquelle 38 kann dann beispielsweise über die Verbindungsleitung 56 einen Teststrom in den Ausgang 45 des Halbleiterschalterpaares 16 und/oder über die Verbindungsleitung 57 einen Teststrom in den Ausgang 46 des Halbleiterschalterpaares 18 einspeisen. Die Steuereinheit 40 steuert während dieses Testschritts zum Testen des Halbleitertrennschalters 27 den Low-Side-Halbleiterschalter des Halbleiterschalterpaares 14, das ausgangsseitig mit dem Halbleitertrennschalter 27 verbunden ist, zum Schließen an. Die übrigen Halbleiterschalter der Leistungsendstufe 10 werden von der Steuereinheit 40 zum Öffnen angesteuert. Die Halbleitertrennschalter 27, 28 und 29 der Leistungsendstufe 10 werden von der Steuereinheit 40 zum Schließen angesteuert. Die Steuereinheit 40 ist ausgebildet, in Abhängigkeit der resultierenden Spannung am Ausgang 12 einen Defekt des Halbleitertrennschalters 27 zu ermitteln. Wenn der Halbleitertrennschalter 27 nämlich defekt ist, also hochohmig ist und nicht schließen kann, wird das Potential am Verbindungsknoten 41 - und das der Verbindungsknoten 42 und 43 über die niederohmigen Statorspulen - von dem geschlossenen Low-Side-Halbleiterschalter 21 nicht auf Masse gezogen. Am Ausgang 12 kann dann eine Spannung erfasst werden, die größer ist als im Vergleich zu einem intakten Halbleitertrennschalter, nämlich Null oder ein kleinerer Spannungswert als bei defektem Halbleitertrennschalter 27.

Der Halbleitertrennschalter 28 kann in gleicher Weise durch Einspeisen eines Teststroms in die Ausgänge 44 und/oder 47 und Schließen des Low-Side-Halbleiterschalters 23 des Halbleiterschalterpaares 16, mit dessen Ausgang 45 der Halbleitertrennschalter 28 verbunden ist, getestet werden.

Der Halbleitertrennschalter 29 kann in gleicher Weise durch Einspeisen eines Teststroms in die Ausgänge 44 und/oder 45 und Schließen des Low-Side-Halbleiterschalters 25 des Halbleiterschalterpaares 18, mit dessen Ausgang 46 der Halbleitertrennschalter 29 verbunden ist, getestet werden.

## Patentansprüche

1. Elektronisch kommutierter Elektromotor (1),
mit wenigstens zwei Statorspulen (7, 8, 9) und einem insbesondere permanentmagnetisch ausgebildeten Rotor (5),
und einer Leistungsendstufe (10) mit Halbleiterschaltern (20, 21, 22, 23, 24, 25), wobei die Leistungsendstufe (10) für jede Statorspule (7, 8, 9) wenigstens ein Halbleiterschalterpaar (14, 16, 18) aufweist, und mit einer Steuereinheit (40), welche mit der Leistungsendstufe (10) verbunden und ausgebildet ist, die Halbleiterschalter (20, 21, 22, 23, 24, 25), zum Bestromen der Statorspulen (7, 8, 9) zum Erzeugen eines magnetischen Drehfeldes anzusteuern, und die Leistungsendstufe (10) wenigstens einen Halbleitertrennschalter (27, 28, 29) aufweist, welcher einen Ausgang eines Halbleiterschalterpaares (14, 16, 18) mit einem Ausgang (12) der Leistungsendstufe (10) verbindet, wobei der Ausgang (12) der Leistungsendstufe (10) mit einer Statorspule (7, 8, 9) verbunden ist,
**dadurch gekennzeichnet, dass**
die Steuereinheit (40) mit den Ausgängen (44, 45, 46) der Halbleiterschalterpaare (14, 16, 18) verbunden und ausgebildet ist, die Halbleiterschalter (20, 21, 22, 23, 24, 25) und die Halbleitertrennschalter (27, 28, 29) zum Öffnen anzusteuern und in wenigstens einen Ausgang (44, 45, 46) einen Teststrom einzuspeisen, und eine an dem Ausgang (12) der Leistungsendstufe (12) erzeugte Ausgangsspannung zu erfassen und in Abhängigkeit der Ausgangsspannung eine Funktion wenigstens eines Halbleiterschalters der Halbleiterschalter (20, 21, 22, 23, 24, 25) zu ermitteln,
wobei die Steuereinheit (40) ausgebildet ist, zum Testen eines Halbleitertrennschalters einen Low-Side-Halbleiterschalter eines Halbleiterschalterpaares zum Schließen anzusteuern und den mit dem Halbleiterschalterpaar verbundenen Halbleitertrennschalter und wenigstens einen weiteren Halbleitertrennschalter zum Öffnen oder zum Schließen anzusteuern und einen Teststrom in wenigstens einen Ausgang eines anderen Halbleiterschalterpaares der Halbleiterschalterpaare einzuspeisen und in Abhängigkeit eines Betrages der resultierenden Spannung des Halbleitertrennschalters am Ausgang (12) der Leistungsstufe (12) im Vergleich zu einem Teststrom bei nicht defektem Halbleitertrennschalter einen Defekt des Halbleitertrennschalters zu ermitteln.

2. Elektromotor (1) nach Anspruch 1,
**dadurch gekennzeichnet, dass**
das Halbleiterschalterpaar (14, 16, 18) einen High-Side-Halbleiterschalter (20, 22, 24) und einen Low-Side-Halbleiterschalter (21, 23, 25) umfasst und die Steuereinheit (40) ausgebildet ist, zum Testen der Low-Side-Halbleiterschalter (21, 23, 25) alle Halbleiterschalter (20, 21, 22, 23, 24, 25) zum Öffnen anzusteuern, und in wenigstens einen Ausgang (44, 45, 46) einen Teststrom einzuspeisen und in Abhängigkeit der Ausgangsspannung am Ausgang (12) einen Defekt wenigstens eines Low-Side-Halbleiterschalters (21, 23, 25) zu ermitteln.

3. Elektromotor (1) nach Anspruch 1 oder 2,
**dadurch gekennzeichnet, dass**
die Steuereinheit (40) ausgebildet ist, einen Betrag eines Verringerns des Teststromes im Vergleich zu einem Teststrom bei einer nicht defekten Leistungsendstufe am Ausgang (12) der Leistungsendstufe (10) zu erfassen und in Abhängigkeit des Betrages einen Defekt, insbesondere einen Kurzschluss, wenigstens eines Low-Side-Halbleiterschalters (21, 23, 25) zu ermitteln.

4. Lenkvorrichtung mit einem Elektromotor (1) nach einem der vorhergehenden Ansprüche.

5. Verfahren zum Betreiben eines elektronisch kommutierten Elektromotors, wobei der Elektromotor eine Leistungsendstufe aufweist, die für jede Statorspule des Elektromotors ein Halbleiterschalterpaar umfassend einen High-Side-Halbleiterschalter und einen Low-Side-Halbleiterschalter und wenigstens einen Halbleitertrennschalter aufweist, wobei der Halbleitertrennschalter einen Ausgang des Halbleiterschalterpaares mit einer Statorspule verbindet, wobei bei dem Verfahren vor einem Betrieb zum Erzeugen eines Drehmoments wenigstens ein Teststrom in einen Ausgang eines Halbleiterschalterpaares eingespeist wird und ein Betrag des über den Halbleitertrennschalter fließenden Teststromes erfasst wird und in Abhängigkeit des Betrages ein Defekt eines Halbleitertrennschalters der Leistungsendstufe ermittelt wird, wobei zum Testen des Halbleitertrennschalters der Low-Side-Halbleiterschalter des Halbleiterschalterpaares zum Schließen angesteuert wird und der mit dem Halbleiterschalterpaar verbundene Halbleitertrennschalter und wenigstens ein weiterer Halbleitertrennschalter zum Öffnen oder zum Schließen angesteuert wird und der Teststrom in wenigstens einen Ausgang eines anderen Halbleiterschalterpaares der Halbleiterschalterpaare eingespeist wird und in Abhängigkeit eines Betrages der resultierenden Spannung des Halbleitertrennschalters am Ausgang (12) der Leistungsstufe (12) im Vergleich zu einem Teststrom bei nicht defektem Halbleitertrennschalter einen Defekt des Halbleitertrennschalters ermittelt wird.

## Claims

1. Electronically commutated electric motor (1), having at least two stator coils (7, 8, 9) and a rotor (5), in particular a permanent magnetic rotor,
and a power output stage (10) having semiconductor switches (20, 21, 22, 23, 24, 25), wherein the power output stage (10) has at least one pair of semiconductor switches (14, 16, 18) for each stator coil (7, 8, 9), and having a control unit (40) which is connected to the power output stage (10) and is designed to control the semiconductor switches (20, 21, 22, 23, 24, 25) to energize the stator coils (7, 8, 9) in order to produce a magnetic rotating field, and the power output stage (10) has at least one semiconductor isolating switch (27, 28, 29) which connects an output of a pair of semiconductor switches (14, 16, 18) to an output (12) of the power output stage (10), wherein the output (12) of the power output stage (10) is connected to a stator coil (7, 8, 9),
**characterized in that**
the control unit (40) is connected to the outputs (44, 45, 46) of the pairs of semiconductor switches (14, 16, 18) and is designed to control the semiconductor switches (20, 21, 22, 23, 24, 25) and the semiconductor isolating switches (27, 28, 29) to open and to feed a test current into at least one output (44, 45, 46) and to capture an output voltage produced at the output (12) of the power output stage (12) and to determine a function of at least one semiconductor switch of the semiconductor switches (20, 21, 22, 23, 24, 25) on the basis of the output voltage,
wherein the control unit (40) is designed, in order to test a semiconductor isolating switch, to control a low-side semiconductor switch of a pair of semiconductor switches to close and to control the semiconductor isolating switch connected to the pair of semiconductor switches and at least one further semiconductor isolating switch to open or to close and to feed a test current into at least one output of another pair of semiconductor switches of the pairs of semiconductor switches and to determine a defect of the semiconductor isolating switch on the basis of a magnitude of the resulting voltage of the semiconductor isolating switch at the output (12) of the power stage (12) in comparison with a test current in the case of a non-defective semiconductor isolating switch.

2. Electric motor (1) according to Claim 1, **characterized in that**
the pair of semiconductor switches (14, 16, 18) comprises a high-side semiconductor switch (20, 22, 24) and a low-side semiconductor switch (21, 23, 25), and the control unit (40) is designed, in order to test the low-side semiconductor switches (21, 23, 25), to control all semiconductor switches (20, 21, 22, 23, 24, 25) to open and to feed a test current into at least one output (44, 45, 46) and to determine a defect of at least one low-side semiconductor switch (21, 23, 25) on the basis of the output voltage at the output (12).

3. Electric motor (1) according to Claim 1 or 2, **characterized in that**
the control unit (40) is designed to capture a magnitude of a reduction in the test current in comparison with a test current in the case of a non-defective power output stage at the output (12) of the power output stage (10) and to determine a defect, in particular a short circuit, of at least one low-side semiconductor switch (21, 23, 25) on the basis of the magnitude.

4. Steering apparatus having an electric motor (1) according to one of the preceding claims.

5. Method for operating an electronically commutated electric motor, wherein the electric motor has a power output stage which has, for each stator coil of the electric motor, a pair of semiconductor switches comprising a high-side semiconductor switch and a low-side semiconductor switch and at least one semiconductor isolating switch, wherein the semiconductor isolating switch connects an output of the pair of semiconductor switches to a stator coil, wherein, in the method, before operation in order to produce a torque, at least one test current is fed into an output of a pair of semiconductor switches and a magnitude of the test current flowing via the semiconductor isolating switch is captured and a defect of a semiconductor isolating switch of the power output stage is determined on the basis of the magnitude, wherein, in order to test the semiconductor isolating switch, the low-side semiconductor switch of the pair of semiconductor switches is controlled to close and the semiconductor isolating switch connected to the pair of semiconductor switches and at least one further semiconductor isolating switch are controlled to open or to close and the test current is fed into at least one output of another pair of semiconductor switches of the pairs of semiconductor switches and a defect of the semiconductor isolating switch is determined on the basis of a magnitude of the resulting voltage of the semiconductor isolating switch at the output (12) of the power stage (12) in comparison with a test current in the case of a non-defective semiconductor isolating switch.

## Revendications

1. Moteur électrique (1) à commutation électronique,
comprenant au moins deux bobines de stator (7, 8, 9) et un rotor (5), en particulier à aimants permanents,
et un étage de sortie de puissance (10) pourvu de commutateurs à semi-conducteur (20, 21, 22, 23, 24, 25), l'étage de sortie de puissance (10) présentant au moins une paire de commutateurs à semi-conducteur (14, 16, 18) pour chaque bobine de stator (7, 8, 9), et comprenant une unité de commande (40) qui est reliée à l'étage de sortie de puissance (10) et est réalisée pour piloter les commutateurs à semi-conducteur (20, 21, 22, 23, 24, 25) pour alimenter en électricité les bobines de stator (7, 8, 9) afin de générer un champ magnétique rotatif, et l'étage de sortie de puissance (10) présente au moins un disjoncteur à semi-conducteur (27, 28, 29) qui relie une sortie d'une paire de commutateurs à semi-conducteur (14, 16, 18) à une sortie (12) de l'étage de sortie de puissance (10), la sortie (12) de l'étage de sortie de puissance (10) étant reliée à une bobine de stator (7, 8, 9),
**caractérisé en ce que** l'unité de commande (40) est reliée aux sorties (44, 45, 46) des paires de commutateurs à semi-conducteur (14, 16, 18) et est réalisée pour piloter en ouverture les commutateurs à semi-conducteur (20, 21, 22, 23, 24, 25) et les disjoncteurs à semi-conducteur (27, 28, 29) et pour alimenter au moins une sortie (44, 45, 46) en courant d'essai, et pour détecter une tension de sortie générée à la sortie (12) de l'étage de sortie de puissance (12) et pour déterminer en fonction de la tension de sortie une fonction d'au moins un commutateur à semi-conducteur des commutateurs à semi-conducteur (20, 21, 22, 23, 24, 25),
dans lequel l'unité de commande (40) est réalisée pour piloter en fermeture un commutateur à semi-conducteur côté bas d'une paire de commutateurs à semi-conducteur pour tester un disjoncteur à semi-conducteur, et pour piloter en ouverture ou en fermeture le disjoncteur à semi-conducteur relié à la paire de commutateurs à semi-conducteur et au moins un autre disjoncteur à semi-conducteur, et pour alimenter en courant d'essai au moins une sortie d'une autre paire de commutateurs à semi-conducteur des paires de commutateurs à semi-conducteur, et pour déterminer un défaut du disjoncteur à semi-conducteur en fonction d'une valeur de la tension résultante du disjoncteur à semi-conducteur à la sortie (12) de l'étage de puissance (12) en comparaison avec un courant d'essai lorsque le disjoncteur à semi-conducteur n'est pas défectueux.

2. Moteur électrique (1) selon la revendication 1, **caractérisé en ce que** la paire de commutateurs à semi-conducteur (14, 16, 18) comprend un commutateur à semi-conducteur côté haut (20, 22, 24) et un commutateur à semi-conducteur côté bas (21, 23, 25), et l'unité de commande (40) est réalisée pour piloter en ouverture tous les commutateurs à semi-conducteur (20, 21, 22, 23, 24, 25) pour tester les commutateurs à semi-conducteur côté bas (21, 23, 25), et pour alimenter en courant d'essai au moins une sortie (44, 45, 46), et pour déterminer un défaut d'au moins un commutateur à semi-conducteur côté bas (21, 23, 25) en fonction de la tension de sortie à la sortie (12).

3. Moteur électrique (1) selon la revendication 1 ou 2, **caractérisé en ce que** l'unité de commande (40) est réalisée pour détecter à la sortie (12) de l'étage de sortie de puissance (10) une valeur d'une réduction du courant d'essai en comparaison avec un courant d'essai lorsque l'étage de sortie de puissance n'est pas défectueux, et pour déterminer un défaut, en particulier un court-circuit, d'au moins un commutateur à semi-conducteur côté bas (21, 23, 25) en fonction de la valeur.

4. Dispositif de direction comprenant un moteur électrique (1) selon l'une quelconque des revendications précédentes.

5. Procédé permettant de faire fonctionner un moteur électrique à commutation électronique, le moteur électrique présentant un étage de sortie de puissance qui présente pour chaque bobine de stator du moteur électrique une paire de commutateurs à semi-conducteur, comprenant un commutateur à semi-conducteur côté haut et un commutateur à semi-conducteur côté bas, et au moins un disjoncteur à semi-conducteur, le disjoncteur reliant une sortie de la paire de commutateurs à semi-conducteur à une bobine de stator, dans lequel, dans le procédé, avant un fonctionnement destiné à générer un couple, au moins un courant d'essai est alimenté dans une sortie d'une paire de commutateurs à semi-conducteur et une valeur du courant d'essai passant par le disjoncteur à semi-conducteur est détectée, et un défaut d'un disjoncteur à semi-conducteur de l'étage de sortie de puissance est déterminé en fonction de la valeur, le commutateur à semi-conducteur côté bas de la paire de commutateurs à semi-conducteur étant piloté en fermeture pour tester le disjoncteur à semi-conducteur, et le disjoncteur à semi-conducteur relié à la paire de commutateurs à semi-conducteur et au moins un autre disjoncteur à semi-conducteur étant pilotés en ouverture ou en fermeture, et le courant d'essai est alimenté dans au moins une sortie d'une autre paire de commutateurs à semi-conducteur de la paire de commutateurs à semi-conducteur, et un défaut du commutateur à semi-conducteur est déterminé en fonction d'une valeur de la tension résultante du disjoncteur à semi-conducteur à la sortie (12) de l'étage de puissance (12) en comparaison avec un courant d'essai lorsque le disjoncteur à semi-conducteur n'est pas défectueux.
